(19) Europäisches Patentamt
European Patent Office
Office européen des brevets

(11) **EP 2 911 299 B1**

(12) **EUROPÄISCHE PATENTSCHRIFT**

(45) Veröffentlichungstag und Bekanntmachung des Hinweises auf die Patenterteilung:
**26.08.2020 Patentblatt 2020/35**

(51) Int Cl.:
***H03K 17/95*** *(2006.01)*

(21) Anmeldenummer: **14155957.5**

(22) Anmeldetag: **20.02.2014**

(54) **Verfahren und Schaltung zum Auswerten einer von einem Sensor erfassten physikalischen Messgröße**

Method and circuit for evaluating a physical measurement value measured by a sensor

Procédé et circuit d'exploitation d'une grandeur de mesure physique enregistrée par un capteur

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**26.08.2015 Patentblatt 2015/35**

(73) Patentinhaber: **Pepperl + Fuchs GmbH**
**68307 Mannheim (DE)**

(72) Erfinder: **Seefried, Roland**
**69121 Heidelberg (DE)**

(74) Vertreter: **Banse & Steglich**
**Patentanwälte PartmbB**
**Patentanwaltskanzlei**
**Herzog-Heinrich-Straße 23**
**80336 München (DE)**

(56) Entgegenhaltungen:
**EP-A1- 1 382 938     EP-A2- 0 537 747**
**EP-A2- 2 146 431     WO-A1-00/76070**
**DE-A1- 3 213 602**

EP 2 911 299 B1

**Beschreibung**

Technisches Gebiet

Die Erfindung betrifft allgemein Sensoren, insbesondere Sensoren, die in einem Oszillator eingesetzt werden, wobei ein von einer physikalischen Messgröße abhängiges Schwingungssignal bereitgestellt wird. Weiterhin betrifft die vorliegende Erfindung Möglichkeiten zur Auswertung eines von einem Sensorelement beeinflussten Schwingungssignals, um eine Sensorgröße zu erhalten.

Stand der Technik

Induktive oder kapazitive Sensorelemente werden häufig in kontaktlos arbeitenden Sensoranwendungen verwendet. Elektrische Eigenschaften von induktiven oder kapazitiven Sensorelementen können sich abhängig von einer physikalischen Messgröße ändern und werden üblicherweise mithilfe von Oszillatoren ausgewertet, um ein von der Messgröße abhängiges Schwingungssignal als Sensorsignal zu generieren.

Zum Beispiel weist ein induktives Sensorelement eine Induktivität zumeist in Form einer Spule auf, die als Teil eines Oszillators mit einem elektrischen Schwingungssignal beaufschlagt wird. Die elektrische Schwingung bewirkt um die Induktivität ein Wechselmagnetfeld. Gelangt ein elektrisch leitender Körper in die Nähe der Induktivität, so bewirkt das Wechselmagnetfeld eine Induktion einer Spannung. Daraus resultieren Wirbelströme in dem Körper, die ein das Wechselmagnetfeld überlagerndes Störmagnetfeld generieren. In dem Oszillator kann sich eine durch das Störmagnetfeld hervorgerufene Impedanzänderung bzw. Störung des Wechselmagnetfeldes in Form einer Erhöhung einer Dämpfung auswirken.

Eine Änderung der Dämpfung in einem Oszillator wirkt sich im Allgemeinen als eine Änderung der Amplituden der elektrischen Schwingung aus, die detektierbar und auswertbar ist. Zur Auswertung wird in herkömmlicher Weise das von dem Oszillator bereitgestellte elektrische Schwingungssignal zunächst mithilfe z.B. einer Diode gleichgerichtet, um eine von der Höhe der Impedanzänderung abhängige Sensorgröße in Form einer elektrischen Gleichgröße bereitzustellen.

Derartige induktive Sensoren werden beispielsweise als induktive Näherungssensoren eingesetzt, um den Abstand eines elektrisch leitfähigen Objekts zum Sensor zu erfassen. Zum Bereitstellen eines für industrielle Anwendungen häufig benötigten binären Schaltsignals kann aus der Sensorgröße mithilfe eines Schmitt-Triggers oder Komparators eine binäre Sensorgröße erzeugt werden.

Aus der Druckschrift DE 10 2004 034 190 A1 ist eine Oszillatorschaltung für einen induktiven oder kapazitiven Sensor bekannt. Die Oszillatorschaltung umfasst einen Schwingkreis und einen Operationsverstärker, wobei eine elektrische Schwingung des Schwingkreises über zwei Anschlüsse differenziell abgegriffen und durch den Operationsverstärker verstärkt wird.

Aus der Druckschrift EP 1 183 779 B1 ist ein Oszillator für einen induktiven Näherungssensor bekannt, der einen Schwingkreis und einen Komparator aufweist. Mithilfe eines Netzwerks mit positiver Rückkopplung wird der Ausgang des Komparators mit dem nicht invertierenden Eingang des Komparators verbunden. Weiterhin wird der Ausgang des Komparators mithilfe eines Netzwerks mit negativer Rückkopplung mit dem invertierenden Eingang des Komparators und dem Ausgang des Komparators verbunden, so dass Oszillationssignale unabhängig davon erzeugt werden, ob ein allmähliches oder schnelles Anlegen von Leistung an den Schwingkreis erfolgt.

Die Druckschrift EP 0 537 747 A2 betrifft ein einen Näherungssensor mit einem Oszillator, dessen Schwingfrequenz sich abhängig von dem Abstand eines leitfähigen Objekts von dem Oszillator einstellt. Mithilfe eines Frequenz-Spannungswandlers wird die Schwingfrequenz des Oszillators in eine repräsentierende Spannung als Sensorgröße umgewandelt.

Die Druckschrift EP 2 146 431 A2 beschreibt einen Näherungssensor mit einer Auswerteeinheit, die einen Oszillator, einen Gleichrichter und eine Signalwandlereinheit aufweist. Die Schwingfrequenz des Oszillators hängt in bekannter Weise von einem Abstand eines zu detektierenden Objekts ab. Die resultierende Schwingfrequenz wird in der Signalwandlereinheit ausgewertet.

Die obigen Druckschriften sehen zur Auswertung des von dem Oszillator erhaltenen Schwingungssignals vor, eine elektrische Wechselgröße bereitzustellen. Diese wird üblicherweise anschließend mithilfe eines oder mehrerer Halbleiterbauelemente, wie beispielsweise in einem Diodengleichrichter oder in einem aktiven Gleichrichter, gleichgerichtet, um eine verwertbare, die zu messende physikalische Messgröße repräsentierende Sensorgröße in Form einer elektrischen Gleichgröße bereitzustellen. Die Verwendung von Diodenschaltungen oder aktiven Gleichrichtern zum Zwecke der Gleichrichtung des Sensorsignals führt jedoch zu einer Temperaturabhängigkeit des Auswertungssignals, die insbesondere in Anwendungsbereichen mit hohen Temperaturschwankungen nachteilig ist.

Auch sind Auswerteschaltungen, die auf einer dioden- oder gleichrichterbasierten Gleichrichtung des Schwingungssignals basieren, in der Regel aufwändig und weisen eine nennenswerte Leistungsaufnahme auf.

Es ist daher Aufgabe der vorliegenden Erfindung, ein Verfahren und eine Schaltung zum Auswerten einer von einem Sensorelement erfassten physikalischen Messgröße bereitzustellen, die dazu in der Lage sind, basierend auf einem von der Messgröße abhängigen elektrischen Schwingungssignal eine Sensorgröße als elektrische Gleichgröße bereitzustellen, die eine nur geringe bzw. keine Temperaturabhängigkeit aufweist. Weiterhin soll die Auswerteschaltung eine geringere Anzahl von Bauelementen benötigen und eine geringe Leistungsaufnahme aufweisen.

Offenbarung der Erfindung

Diese Aufgabe wird durch das Verfahren zum Messen einer von einer physikalischen Messgröße abhängigen elektrischen Schwingungsgröße mit einem Sensorelement und zum Bereitstellen einer von der Messgröße abhängigen Sensorgröße gemäß Anspruch 1 sowie durch die Auswerteschaltung gemäß dem nebengeordneten Anspruch gelöst.

Weitere Ausgestaltungen sind in den abhängigen Ansprüchen angegeben.

Gemäß einem ersten Aspekt ist ein Verfahren zum Messen einer physikalischen Messgröße mit einem, insbesondere induktiven, Sensorelement und zum Bereitstellen einer von der Messgröße abhängigen Sensorgröße vorgesehen. Das Sensorelement ist Teil eines Schwingkreises, der eine von der physikalischen Messgröße abhängige Dämpfung aufweist. Der Schwingkreis wird angeregt, um ein periodisches Schwingungssignal zu generieren, dessen Amplitude von der Dämpfung abhängt. Weiterhin wird das Schwingungssignal mithilfe eines Komparators mit einem Komparatorschwellenwert verglichen, um ein periodisches Komparatorsignal mit einem von dem Komparatorschwellenwert abhängigen Tastverhältnis zu erhalten. Dabei wird der Komparatorschwellenwert gegenüber einem Mittelwert des Schwingungssignals so verstellt, dass sich ein von 50% verschiedenes Tastverhältnis einstellt. Die Sensorgröße kann dann als eine von dem Tastverhältnis des Komparatorsignals abhängige Größe bereitgestellt werden.

Eine Idee des obigen Verfahrens besteht grundsätzlich darin, ein von einem elektrischen Schwingkreis mit einem Sensorelement bereitgestelltes Schwingungssignal, dessen Amplitude von der zu messenden physikalischen Messgröße abhängt, so auszuwerten, dass eine von der Amplitude des Schwingungssignals abhängige Sensorgröße als elektrische Gleichspannung bzw. Gleichstrom bereitgestellt wird.

Bei herkömmlichen Ansätzen wird dazu das Schwingungssignal des Schwingkreises verstärkt und anschließend gleichgerichtet, zum Beispiel mithilfe einer Diode oder eines aktiven Gleichrichters, um das Sensorsignal zu erhalten. Da Halbleiterbauelemente in der Regel eine Temperaturabhängigkeit aufweisen, führt eine derartige Auswerteschaltung zu einer Sensorgröße, die von der Amplitude des Schwingungssignals, aber auch von der Temperatur der Auswerteschaltung abhängt. Dies kann insbesondere in einigen Einsatzgebieten nachteilig sein, in denen hohe Temperaturschwankungen auftreten können.

Das obige Verfahren ermöglicht es auf einfache Weise, eine Auswerteschaltung mit einer reduzierten Anzahl von Bauelementen und insbesondere ohne die Verwendung eines Gleichrichters zum Bereitstellen der temperaturunabhängigen Sensorgröße als Gleichspannung bzw. Gleichstrom bereitzustellen. Die Temperaturunabhängigkeit wird im Wesentlichen dadurch erreicht, dass der Komparatorschwellenwert, bezüglich dessen das Schwingungssignal ausgewertet wird, abweichend von einem Mittelwert des Schwingungssignals eingestellt wird. Dadurch gibt der Komparatorschwellenwert eine Schaltschwelle vor, die vom Mittelwert des Schwingungssignals verschieden bzw. dazu verschoben ist. Dadurch erhält man am Ausgang des Komparators ein periodisches Komparatorsignal mit einem von 50% abweichenden Tastverhältnis.

Das Einstellen des Komparatorsignals mit einem von 50% abweichenden Tastverhältnis basiert auf der durch den Komparatorschwellenwert eingestellten Schaltschwelle, die das periodische Schwingungssignal zu bestimmten Zeitpunkten über- bzw. unterschreitet. Diese Zeitpunkte hängen jedoch bei einer von dem Mittelwert des Schwingungssignals verschiedenen Schaltschwelle von der Steilheit des Schwingungssignals ab. Da die Steilheit des Schwingungssignals wiederum von der Amplitude des Schwingungssignals abhängt, ist das Tastverhältnis bei einer von dem Mittelwert des Schwingungssignals verschiedenen Schaltschwelle von der Amplitude des Schwingungssignals abhängig. Mit anderen Worten wird die Komparatorschwelle so eingestellt, dass das Schwingungssignal an einer zeitlichen Position abgetastet wird, die von der Amplitude des Schwingungssignals abhängig ist.

Der Sensorgröße kann dann durch Bilden des Durchschnittswerts des Komparatorsignals, z. B. durch Glätten, erhalten werden. Dadurch wird ermöglicht, Dioden oder sonstige aktive Halbleiterbauelemente mit einer signifikanten Temperaturabhängigkeit für eine Gleichrichtung des Schwingungssignals zu vermeiden.

Weiterhin kann der Mittelwert des Schwingungssignals gegenüber dem Komparatorschwellenwert mithilfe eines vorgegebenen Offsetwerts, insbesondere einer vorgegebenen Offsetspannung, verstellt werden, wobei das Schwingungssignal mit dem Offsetwert beaufschlagt wird oder der Komparatorschwellenwert dem Offsetwert entspricht oder abhängig von dem Offsetwert eingestellt wird.

Es kann vorgesehen sein, dass der Komparatorschwellenwert abhängig von dem Tastverhältnis des periodischen Komparatorsignals eingestellt wird.

Insbesondere kann der Komparatorschwellenwert als der, insbesondere durch Glätten, erhaltene Durchschnittswert des periodischen Komparatorsignals eingestellt werden, wobei die Sensorgröße dem Durchschnittswert entspricht.

Gemäß einer Ausführungsform kann eine Oszillation des Schwingkreises durch gleichphasige Rückkopplung des periodischen Komparatorsignals aufrechterhalten werden.

Das Komparatorsignal kann tiefpassgefiltert werden, wobei ein Anschwingen des Schwingkreises durch Rückkopplung des tiefpassgefilterten Komparatorsignals auf den Komparatorschwellenwert bewirkt wird.

Gemäß einer Ausführungsform kann der Komparatorschwellenwert abhängig von dem Tastverhältnis des periodischen Komparatorsignals und abhängig von einem vorgegebenen Offsetwert gegenüber einem Mittelwert des Schwingungssignals verstellt werden, so dass sich ein Gleichgewichtszustand zwischen einem sich aufgrund des vorgegebenen Offsetwerts einstellenden Tastverhältnis und einem sich abhängig von dem Komparatorschwellenwert einstellenden Tastverhältnis ergibt.

Dadurch wird eine Rückkopplung von dem Ausgang des Komparators vorgesehen, wodurch der Komparatorschwellenwert abhängig von dem Tastverhältnis des Komparatorsignals am Ausgang des Komparators eingestellt wird. Die Abhängigkeit kann so gewählt sein, dass mit einer ansteigenden Abweichung des Tastverhältnisses von 50 % der Komparatorschwellenwert zunehmend in Richtung des Mittelwerts des Schwingungssignals verschoben wird. Auf diese Weise stellt sich am Ausgang des Komparators ein Tastverhältnis des Komparatorsignals ein, das von der Verstimmung des Komparatorschwellenwerts gegenüber dem Mittelwert des Schwingungssignals und der Amplitude des Schwingungssignals abhängt. Somit kann als Sensorgröße der Komparatorschwellenwert als Gleichspannung herangezogen werden.

Insbesondere die Abweichung zwischen dem vorgegebenen Offsetwert und dem sich aus dem Tastverhältnis des Komparatorsignals ergebenden Komparatorschwellenwert führt dazu, dass sich ein Gleichgewichtszustand einstellt. Dadurch entsteht eine Abhängigkeit zwischen dem Komparatorschwellenwert und der Amplitude des periodischen Schwingungssignals. Die Bereitstellung des Komparatorschwellenwerts als von der Amplitude des Schwingungssignals abhängige Gleichspannung ermöglicht es, auf eine Gleichrichtung des Komparatorausgangssignals zu verzichten und den Komparatorschwellenwert als bereitgestellte Sensorgröße zu verwenden.

Weiterhin kann die Messgröße einer Spannung des Komparatorschwellenwerts oder einer effektiven, durch Glättung des periodischen Komparatorsignals erhaltenen Spannung entsprechen.

Gemäß einer weiteren Ausführungsform kann der Schwingkreis gegenphasig durch das periodische Komparatorsignal angeregt werden.

Gemäß einem weiteren Aspekt kann eine Auswerteschaltung zum Messen einer physikalischen Messgröße mit einem, insbesondere induktiven, Sensorelement und zum Bereitstellen einer von der Messgröße abhängigen Sensorgröße vorgesehen sein, wobei die Auswerteschaltung umfasst:

- einen das Sensorelement umfassenden Schwingkreis, der eine von der physikalischen Messgröße abhängige Dämpfung aufweist;
- eine Einrichtung zum Bereitstellen eines Anregungssignals zum Anregen des Schwingkreises, um ein periodisches Schwingungssignal zu generieren, dessen Amplitude von der Dämpfung des Schwingkreises abhängt;
- einen Komparator, um das Schwingungssignal mit einem Komparatorschwellenwert zu vergleichen, so dass ein resultierendes periodisches Komparatorsignal mit einem von dem Komparatorschwellenwert abhängigen Tastverhältnis bereitgestellt wird, wobei die Sensorgröße als eine von dem Tastverhältnis des Komparatorsignals abhängige Größe bereitgestellt wird; und
- eine Einrichtung zum Verstellen des Komparatorschwellenwerts gegenüber einem Mittelwert des Schwingungssignals, so dass sich ein von 50% verschiedenes Tastverhältnisses einstellt.

Weiterhin kann eine Offsetspannungsquelle vorgesehen sein, um den Mittelwert des Schwingungssignals gegenüber dem Komparatorschwellenwert mithilfe eines vorgegebenen Offsetwerts, insbesondere einer vorgegebenen Offsetspannung, zu verstellen, wobei die Offsetspannungsquelle so geschaltet ist, dass das Schwingungssignal mit dem Offsetwert beaufschlagt wird oder der Komparatorschwellenwert dem Offsetwert entspricht oder abhängig von dem Offsetwert eingestellt wird.

Die Einrichtung zum Bereitstellen des Anregungssignals kann durch eine Rückkopplung des Komparatorsignals, insbesondere mithilfe eines Rückkopplungswiderstands, auf den Schwingkreis vorgesehen sein, um den Schwingkreis durch das periodische Komparatorsignal anzuregen, so dass dieser insbesondere bei seiner Resonanzfrequenz kontinuierlich schwingt.

Insbesondere kann eine Anschwingeinrichtung vorgesehen sein, um das periodische Komparatorsignal tiefpasszufiltern und um den Komparatorschwellenwert als das tiefpassgefilterte Komparatorsignal oder als ein von dem tiefpassgefilterten Komparatorsignal abhängiges Signal bereitzustellen, um ein Anschwingen des Schwingkreises zu ermöglichen, wobei das tiefpassgefilterte Komparatorsignal als die Sensorgröße bereitgestellt wird.

Das Sensorelement kann eine Induktivität aufweisen, wobei der Schwingkreis die Induktivität aufweist, deren Anschlüsse jeweils über Schwingkreiskapazitäten mit einem festgelegten Potenzial gekoppelt sind, wobei die Rückkopplung des Komparatorsignals auf den Schwingkreis gegenphasig erfolgt.

Kurzbeschreibung der Zeichnungen

Ausführungsformen werden nachfolgend anhand der beigefügten Zeichnungen näher erläutert. Es zeigen:

Fig. 1    eine schematische Darstellung einer Auswerteschaltung für einen Sensor;

Fig. 2    eine Darstellung eines Verlaufs zweier beispielhafter Schwingungssignale verschiedener Amplitude sowie der daraus resultierenden Komparatorsignale;

Fig. 3    eine Darstellung einer Ausführungsform einer Auswerteschaltung für einen induktiven Sensor;

Fig. 4    eine schematische Darstellung des zeitlichen Verlaufs des Schwingungssignals als ein idealisiert sinusförmiges Signal;

Fig. 5    eine schematische Darstellung der nahezu linearen Abhängigkeit zwischen der Amplitude des Schwingungssignals und der Ausgangsgröße; und

Fig. 6    eine Darstellung eines Schaltplans für eine Auswerteschaltung für einen induktiven Sensor gemäß einer weiteren Ausführungsform.

Beschreibung von Ausführungsformen

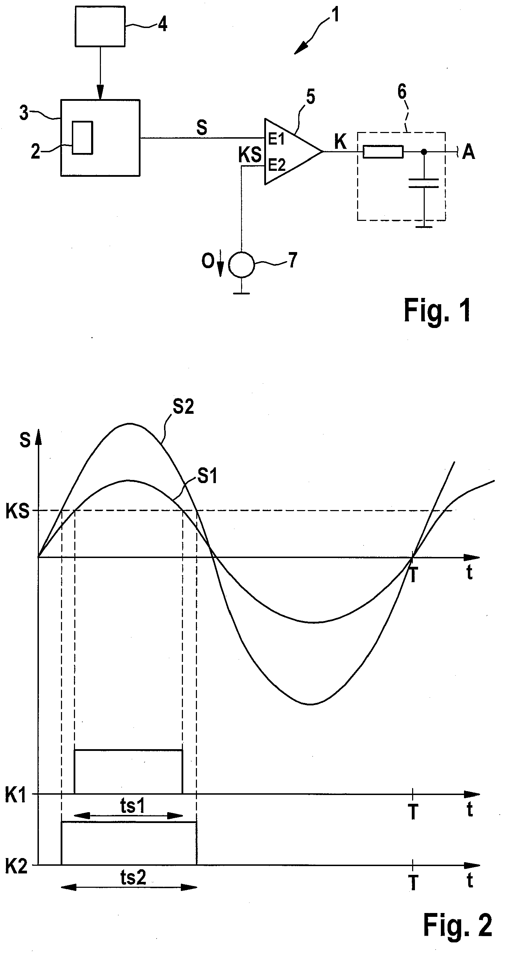

Figur 1 zeigt eine schematische Darstellung einer Auswerteschaltung 1 für ein Sensorelement 2, das Teil eines Schwingkreises 3 bzw. Oszillators ist. Das Sensorelement 2 dient zum Erfassen einer physikalischen Messgröße und zum Beeinflussen des Schwingkreises 3 derart, dass ein periodisches Schwingungssignal mit einer von der physikalischen Messgröße abhängigen Amplitude generiert wird. Beispielsweise kann das Sensorelement 2 so gewählt sein, dass eine Änderung der zu erfassenden physikalischen Messgröße zu einer Impedanzänderung des Sensorelements 2 führt. Die Impedanzänderung resultiert in dem Schwingkreis 3 in einer veränderten Dämpfung des periodischen Schwingungssignals, die ausgewertet werden kann.

Der Schwingkreis 3 wird mithilfe einer Anregungseinrichtung 4 kontinuierlich zum Bereitstellen des periodischen Schwingungssignals S angeregt. Die Anregungseinrichtung 4 dient einerseits dazu, beim Starten der Auswerteschaltung 1 ein Anschwingen des Schwingkreises 3 zu bewirken, und andererseits dazu, ein kontinuierliches Schwingen des Schwingkreises 3 durch Einbringen gleichbleibender Anregungsenergie aufrecht zu erhalten. Insbesondere erfolgt die Anregung durch Beaufschlagen mit einem Anregungssignal, das einen Frequenzanteil mit einer Resonanzfrequenz des Schwingkreises 3 aufweist.

Das periodische Schwingungssignal S wird einem ersten Eingang E1 eines Komparators 5 zugeführt und dort mit einem an einem zweiten Eingang E2 bereitgestellten vorgegebenen Komparatorschwellenwert KS, insbesondere in Form einer Spannung, verglichen. Ein am Ausgang des Komparators 5 resultierendes Komparatorsignal K entspricht einem Rechteckspannungssignal mit der Periodizität des periodischen Schwingungssignals S.

Der Komparatorschwellenwert KS kann von einer Offset-Einheit 7 vorgegeben werden, die beispielsweise als eine mit dem zweiten Eingang E2 des Komparators 5 verbundene Offsetspannungsquelle 7 ausgebildet sein kann.

Die Offset-Einheit 7 dient dazu, mithilfe eines Offsetwerts O, der als eine Offsetspannung $U_o$ angegeben werden kann, den Komparatorschwellenwert KS so vorzugeben, dass dieser gegenüber einem Mittelwert des Schwingungssignals S verschoben bzw. von dem Mittelwert des Schwingungssignals S verschieden ist.

Als Mittelwert kann ein mittlerer Wert aus einem Maximum und einem Minimum des Schwingungssignals verwendet werden. Als Mittelwert kann auch das durch die Periodendauer der Schwingung dividierte Integral des Verlaufs des Schwingungssignals über eine Periodendauer verwendet werden.

Das Schwingungssignal S kann im Wesentlichen einem elektrischen Signal mit nahezu sinusförmigem Verlauf entsprechen, wobei ein Mittelwert aus dem maximalen und dem minimalen Signalwert bestimmt sein kann. Die durch den Komparatorschwellenwert KS definierte Komparatorschwelle bezüglich des Schwingungssignals S wird dann als ein Wert zwischen dem Mittelwert und dem maximalen Wert oder zwischen dem Mittelwert und dem minimalen Wert des Schwingungssignals S vorgegeben. Auf diese Weise kann der Komparatorschwellenwert KS gegenüber dem Mittelwert des Schwingungssignals S verstimmt werden.

Das Komparatorsignal K am Ausgang des Komparators 5 wird einem Tiefpassfilter 6 zugeführt, der z. B. als RC-Glied ausgebildet ist. Der Tiefpassfilter 6 dient dazu, das Komparatorsignal K zu glätten und eine zu dem Tastverhältnis des Komparatorsignals K proportionale Sensorgröße A als elektrische Gleichgröße, insbesondere als Sensorspannung, bereitzustellen.

Würde der Komparatorschwellenwert KS auf den Mittelwert des Schwingungssignals S eingestellt, so stellte sich am Ausgang des Komparators 5 ein Komparatorsignal K mit einem Tastverhältnis von 50% ein. Beim Verstellen des Komparatorschwellenwerts KS bezüglich des Mittelwerts des Schwingungssignals S ergibt sich ein Tastverhältnis des Komparatorsignals K, das von 50% abweicht, da die Schaltschwelle des Komparators 5 die sinusförmige Verlaufskurve des Schwingungssignals S zu von dem Nulldurchgang verschiedenen Zeitpunkten schneidet.

Das Tastverhältnis, das sich aufgrund des bezüglich des Mittelwerts des Schwingungssignals S verstimmten Komparatorschwellenwerts KS ergibt, hängt zum einen von dem Betrag des Komparatorschwellenwerts KS bzw. von dessen Abstand zum Mittelwert des Schwingungssignals S ab und zum anderen von der Amplitude des Schwingungssignals S. Wie aus dem in Fig. 2 dargestellten Verlauf zweier beispielhafter sinusförmiger Schwingungssignale S1, S2 verschiedener Amplitude ersichtlich ist, ergibt sich das sich einstellende Tastverhältnis des Komparatorsignals K aus den unterschiedlichen Steilheiten des Schwingungssignals S zum Zeitpunkt der durch den Komparatorschwellenwert KS bestimmten Schaltschwellen. So ist bei einer Periodendauer T und bei einem ersten Schwingungssignal S1 mit geringerer Amplitude das Tastverhältnis ts1/T des resultierenden ersten Komparatorsignals K1 geringer als das Tastverhältnis ts2/T des resultierenden zweiten Komparatorsignals K2 bei dem zweiten Schwingungssignal S2 mit höherer Amplitude, wobei ts1 und ts2 die Zeitdauern angeben, zu denen das jeweilige Schwingungssignal S, S1, S2 einen größeren Signalwert aufweist als der Komparatorschwellenwert KS vorgibt.

In alternativen Ausführungsformen kann auch das Schwingungssignal S mit dem Offsetwert O beaufschlagt werden, indem die Offset-Einheit 7 im Signalpfad des Schwingkreises 3 angeordnet wird. Dadurch addieren sich der Offsetwert O und das Schwingungssignal S. An den zweiten Eingang E2 des Komparators 5 wird dann lediglich ein vorgegebener Vergleichswert, z. B. in Form eines vorgegeben Spannungspotenzials, angelegt. Selbstverständlich muss für die Dimensionierung des Offsetwerts O, des Vergleichswerts und des Schwingkreises 3 der Arbeitsbereich des Komparators 5 berücksichtigt werden.

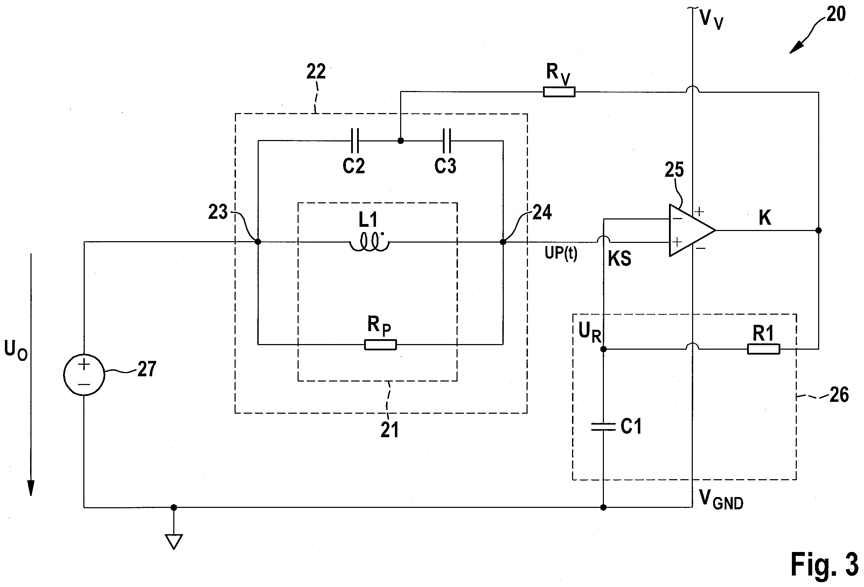

In Fig. 3 ist als Beispiel für die Auswerteschaltung 1 ein konkreteres Schaltbild für eine Auswerteschaltung 20 für einen induktiven Sensor dargestellt. Der induktive Sensor umfasst ein Sensorelement 21, das im dargestellten Schaltbild als eine Induktivität L1 dargestellt ist. Die Induktivität L1 ist parallel zu zwei in Serie geschalteten Schwingkreiskapazitäten C2 und C3 geschaltet, um einen Schwingkreis 22 auszubilden. Eine Oszillation des Schwingkreises 22 führt zu einem Wechselstrom durch die als Spule ausgeführte Induktivität L1, wodurch ein Wechselmagnetfeld ausgebildet wird.

Bei Verwendung des induktiven Sensors als induktiver Näherungssensor kann erfasst werden, ob ein Gegenstand mit einem elektrisch leitenden Element seine Position in dem Wechselmagnetfeld ändert bzw. durch Annäherung an den induktiven Sensor in das Wechselmagnetfeld gelangt. Dies bewirkt in elektrisch leitenden Elementen die Entstehung von Wirbelströmen, die mit dem Wechselmagnetfeld wechselwirken und zu einer Störung des erzeugten Wechselmagnetfeldes führen. Diese Störung des Wechselmagnetfeldes wirkt sich als veränderte Impedanz des Sensorelements 21 bzw. als veränderte Dämpfung der Schwingung im Schwingkreis 22 aus. Diese Dämpfung wird daher durch den parallel zu der Induktivität L1 geschalteten Widerstand Rp im Schwingkreis 22 elektrisch abgebildet.

Der Schwingkreis 22 ist als Parallelschwingkreis ausgebildet und weist einen ersten Anschluss 23 auf, der mit einer vorgegebenen Offsetspannung $U_o$ aus einer entsprechenden Offsetspannungsquelle 27 beaufschlagt ist, und einen zweiten Anschluss 24, der an einem nicht invertierenden Eingang eines Komparators 25 angelegt ist. Der Komparator 25 kann beispielsweise als Differenzverstärker oder Operationsverstärker ausgebildet sein. Somit liegt an dem nicht invertierenden Eingang des Komparators 25 eine Spannung an, die einer Summe aus der Offsetspannung $U_o$ und einer Schwingkreisspannung, die dem Schwingungssignal S entspricht, an.

Der Komparator 25 wird mit einer Versorgungsspannung $U_v$, d. h. einer Spannung zwischen einem hohen Versorgungspotenzial $V_v$ und einem niedrigen Versorgungspotenzial $V_{GND}$, insbesondere einem Massepotenzial, mit elektrischer Energie versorgt. Der Komparator 25 ist vorzugsweise als Rail-to-Rail-Komparator ausgebildet, d. h. es wird bei positivem Bewertungsergebnis im Wesentlichen das hohe Versorgungspotenzial $V_v$ und bei einem negativen Bewertungsergebnis das niedrige Versorgungspotenzial $V_{GND}$ am Komparatorausgang als Komparatorsignal K, das vorzugsweise einem Spannungssignal entspricht, ausgegeben.

Das Komparatorsignal K ist über einen Rückkopplungswiderstand $R_v$ in einen Knoten zwischen die beiden Schwingkreiskapazitäten C2 und C3 eingekoppelt, um eine permanente Anregung für den Schwingkreis 22 bereitzustellen, so dass sich in dem Schwingkreis 22 ein konstantes Oszillationsverhalten bei dessen Resonanzfrequenz ergibt. Dies ist möglich, da das Komparatorsignal K als Rechtecksignal eine Periode aufweist, die der Periode des Schwingungssignals S entspricht. Dadurch weist das Komparatorsignal K selbst bei einem Tastverhältnis von ungleich 50% einen Frequenzanteil auf, der zur vorwiegend gleichphasigen Anregung des Schwingkreises 22 über die Rückkopplung des Rückkopplungswiderstands $R_v$ genügt. Es ist selbstverständlich ebenfalls möglich, die Anregung des Schwingkreises 22 und das Aufrechterhalten der Oszillation durch eine separate Anregungseinrichtung 4, die von dem Komparatorsignal K unabhängig ist, zu bewirken.

Das Komparatorsignal K, das im Wesentlichen ein Rechtecksignal mit einem Tastverhältnis und mit Signalpegeln ist, die dem hohen Versorgungspotenzial $V_v$ und dem niedrigen Versorgungspotenzial $V_{GND}$ entsprechen, wird über einen Tiefpassfilter 26 auf einen invertierenden Eingang des Komparators 25 rückgekoppelt. Der Tiefpassfilter 26 umfasst einen Filterwiderstand R1 und eine Filterkapazität C1, die in Reihe geschaltet sind, so dass sich an einem Knoten zwischen dem Filterwiderstand R1 und der Filterkapazität C1 eine Referenzspannung $U_R$ ergibt, die als Komparatorschwellenwert KS bzw. als Komparatorschwellenspannung an den invertierenden Eingang des Komparators 25 angelegt ist.

Der so gebildete Tiefpassfilter 26 ist so ausgebildet, dass beim Einschalten der Auswerteschaltung 20 an dem invertierenden Eingang des Komparators 25 die Referenzspannung $U_R$ mit zu Beginn starkem und anschließend abnehmendem Schwingen anliegt. Die zu Beginn starke Welligkeit der Referenzspannung $U_R$ führt zu einem wechselnden Signalpegel des Komparatorsignals K, das durch den Rückkopplungswiderstand $R_v$ in den Knoten zwischen die beiden Schwingkreiskapazitäten C2 und C3 eingekoppelt wird. Dadurch unterstützt die Rückkopplung auf den invertierenden Eingang des Komparators 25 das Anschwingen durch anfängliches Erzeugen eines Komparatorsignals K mit periodisch wechselnden Signalpegeln bis der Schwingkreis 22 basierend auf der Rückkopplung durch den Rückkopplungswiderstand $R_v$ die Oszillation aufgenommen hat.

Im eingeschwungenen Zustand bewirkt der Tiefpassfilter 26 weiterhin die Bereitstellung der Referenzspannung $U_R$ an dem invertierenden Eingang des Komparators 25, die durch Glättung des Komparatorsignals K im Wesentlichen als Gleichspannung bereitgestellt wird.

Im Wesentlichen stellt sich dadurch als Referenzspannung $U_R$ eine Spannung ein, die durch das sich im eingeschwungenen Zustand des Schwingkreises 22 einstellende Tastverhältnis des Komparatorsignals K sowie durch das hohe Versorgungspotenzial $V_v$ und das niedrige Versorgungspotenzial $V_{GND}$ gebildet wird. Durch den Komparator 25 bzw. die Potenziale des hohen und niedrigen Pegels sowie durch den Tiefpassfilter 26 wird die Referenzspannung $U_R$ so gebildet, dass eine von dem Tastverhältnis des Komparatorsignals K abhängige Spannung an dem invertierenden Eingang des Komparators 25 anliegt. Im vorliegenden Ausführungsbeispiel entspricht die Referenzspannung $U_R$ bei einem Tastverhältnis von 50% der halben Versorgungsspannung $U_v/2$.

Im wesentlichen weist das in dem Schwingkreis 22 generierte Schwingungssignal einen sinusförmigen Verlauf auf, dessen Mittelwert durch die Offsetspannung $U_o$ bestimmt ist. Ist die Auswerteschaltung 20 abgestimmt, d. h. die Offsetspannung $U_o$ entspricht der Referenzspannung $U_R$, so stellt sich als Komparatorsignal K am Ausgang des Komparators 25 ein Signal mit einem Tastverhältnis von 50% ein. Die Auswerteschaltung 20 ist dagegen verstimmt, wenn die sich aus dem Tastverhältnis des Komparatorsignals K ergebende Referenzspannung $U_R$ einem anderen Spannungsniveau als der Offsetspannung $U_o$ entspricht. Die Verstimmung bewirkt, dass das mit der Offsetspannung $U_o$ beaufschlagte Schwingungssignal up(t) nicht mit einem Komparatorschwellenwert KS abgetastet wird, der dem Mittelwert des Schwingungssignals up(t) entspricht, und am Ausgang des Komparators 25 ein Komparatorsignal K generiert wird, dessen Tastverhältnis von einem Tastverhältnis von 50% abweicht. Dadurch ändert sich die Referenzspannung $U_R$ und es stellt sich ein Gleichgewichtszustand ein, in dem das sich einstellende Tastverhältnis des Komparatorsignals K eine Referenzspannung $U_R$ bewirkt, die von dem Mittelwert der Schwingung so abweicht, das sich als Komparatorsignal K ein Signal mit dem entsprechenden Tastverhältnis einstellt.

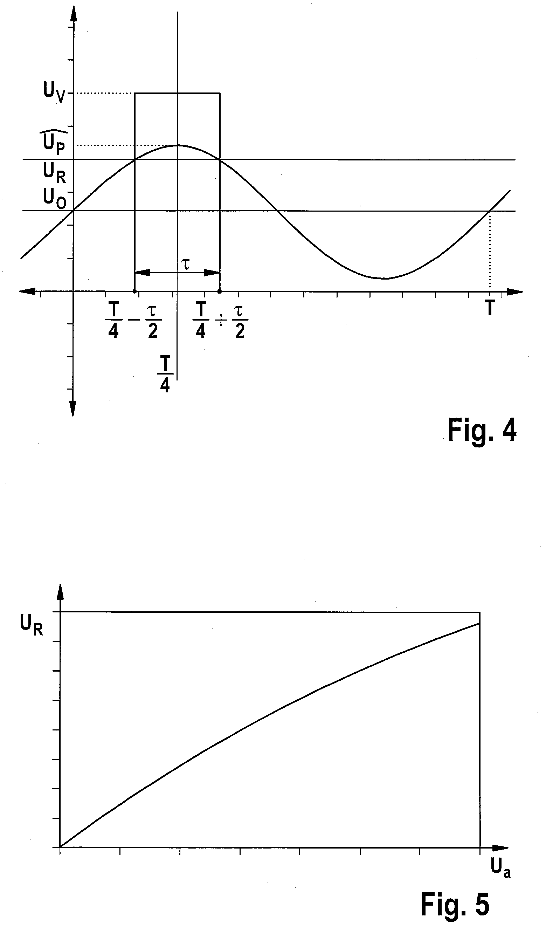

In Figur 4 ist für die Auswerteschaltung 20 der Figur 3 schematisch der zeitliche Verlauf des Schwingungssignals S als ein idealisiert sinusförmiges Signal dargestellt. Es gilt:

$$U_a = \widehat{Up} - Uo$$

$$up(t) = Uo + U_a \sin(\omega t)$$

wobei $U_a$ der Amplitude der Schwingung, $\widehat{Up}$ dem maximalen Signalwert des Schwingungssignals S und up(t) dem Schwingungssignal S entspricht. Weiterhin gilt aufgrund der Rückkopplung durch den Tiefpassfilter 26 im eingeschwungenen Zustand:

$$U_R = \frac{\tau}{T} Uv$$

$$t_1 = \frac{T}{4} - \frac{\tau}{2}$$

Daraus folgt:

$$\frac{\tau}{T} = \frac{1}{2} - \frac{1}{\pi} \arcsin\left(\frac{\frac{\tau}{T}Uv - Uo}{U_a}\right) \approx \frac{1}{2} - \frac{1}{\pi}\left(\frac{\frac{\tau}{T}Uv - Uo}{U_a}\right)$$

und damit

$$U_R \approx \frac{1}{2} - \frac{1}{\pi}\left(\frac{\frac{\tau}{T}Uv - UO}{U_a}\right)Uv$$

und somit

$$\frac{\tau}{T} = \frac{\pi U_a + 2Uo}{2(\pi U_a + Uv)}$$

Es ergibt sich ein Verlauf der Referenzspannung $U_R$ als Sensorsignal bzw. Sensorgröße A über der Amplitude $U_a$ des Schwingungssignals S bzw. up(t), wie es in Figur 5 dargestellt ist. Man erkennt, dass die Sensorgröße A, d.h. die Referenzspannung $U_R$, im Wesentlichen einer Gleichspannung entspricht, die etwa linear zur Amplitude $U_a$ des Schwingungssignals up(t) verläuft. Somit ist die Auswerteschaltung 20 geeignet, die Referenzspannung $U_R$ als repräsentative Sensorgröße A für die Amplitude $U_a$ des Schwingungssignals S bzw. für die sich in der Amplitude $U_a$ des Schwingungssignals S widerspiegelnde physikalische Messgröße heranzuziehen. Das Bereitstellen der Referenzspannung $U_R$ erfolgt als Gleichspannung, und somit ist keine weitere Gleichrichtung notwendig.

Da der Komparator 25 als einziges aktives elektronisches Bauelement der Auswerteschaltung 20 vorzugsweise als Rail-to-Rail-Komparator ausgebildet werden kann, ist eine Temperaturabhängigkeit der Auswerteschaltung 20 gemessen an der Ausgangsgröße gering und beschränkt sich insbesondere nur auf eine Schaltschwelle des Komparators 25.

Im Wesentlichen ist die Rückkopplung des Komparatorausgangs auf den invertierenden Eingang des Komparators 25 dazu vorgesehen, ein Anschwingen des Schwingkreises 22 zu initiieren, so dass durch die Rückkopplung des Komparatorausgangs auf den Schwingkreis 22 die Schwingung aufrechterhalten werden kann. Da jedoch die Rückkopplung auf den invertierenden Eingang des Komparators 25 mithilfe eines Tiefpassfilters 26 erfolgt, kann dieser auch gleichzeitig zur Bereitstellung der Sensorgröße A genutzt werden. Mit anderen Worten entspricht die Referenzspannung $U_R$ der Sensorgröße A, deren Potenzial von der Amplitude $U_a$ des Schwingungssignals S abhängt. Dadurch ist es möglich auf eine dem Komparator 25 nachgeschaltete Einrichtung, wie beispielsweise einen weiteren Tiefpassfilter, einen Gleichrichter oder dergleichen, zu verzichten und stattdessen die Referenzspannung $U_R$ als Sensorgröße A zu verwenden. Insgesamt wird dadurch eine Auswertungsschaltung 20 zur Verfügung gestellt, die ohne passive oder aktive Gleichrichtung auskommt und dadurch die Anzahl der verwendeten Bauelemente und die gesamte Stromaufnahme reduziert.

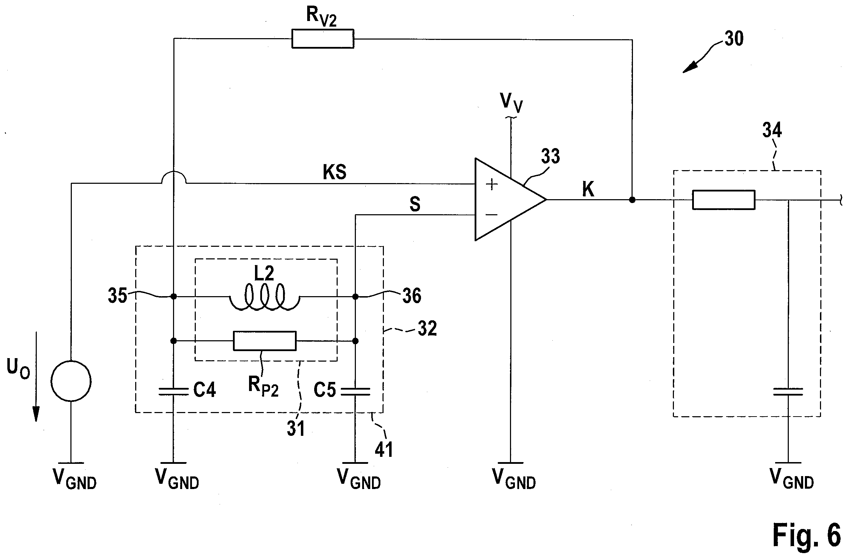

Figur 6 zeigt das Schaltbild einer weiteren, gegenüber der Auswerteschaltung 1 konkretisierten Ausführungsform einer Auswerteschaltung 30 für einen induktiven Sensor mit einem Sensorelement 31 mit einer Induktivität L2, die mit einer ersten und einer zweiten Schwingkreiskapazität C4, C5 einen Schwingkreis 32 bildet. Der Schwingkreis 32 wird gebildet durch eine Verschaltung, bei der ein erster Anschluss 35 der Induktivität L2 über die erste Schwingkreiskapazität C4 mit einem niedrigen Versorgungspotenzial $V_{GND}$, insbesondere einem Massepotenzial, und ein zweiter Anschluss 36 der Induktivität L2 über die zweite Schwingkreiskapazität C5 mit dem niedrigen Versorgungspotenzial $V_{GND}$ verbunden ist. Störungen im Wechselmagnetfeld der als Spule ausgebildeten Induktivität L2 führen zu einer Impedanzänderung bzw. einer Dämpfung einer Schwingung des Schwingkreises 32, die im Schaltbild durch den parallel zur Induktivität L2 geschalteten Widerstand $R_{P2}$ abgebildet wird.

Der zweite Anschluss 36 der Induktivität L2 stellt das Schwingungssignal S an einen invertierenden Eingang des Komparators 33 bereit. Dadurch kann der Schwingkreis 32 über einen Rückkopplungswiderstand $R_{V2}$ über den ersten Anschluss 35 der Induktivität L2 zumindest vorwiegend gegenphasig angeregt werden. An dem nicht invertierenden Eingang des Komparators 33 ist die vorgegebene Offsetspannung $U_o$ als Komparatorschwellenwert KS angelegt.

Der Rückkopplungswiderstand $R_{V2}$ dient dazu, in Verbindung mit der ersten Schwingkreiskapazität C4 ein Anschwingen des Schwingkreises 32 zu bewirken. Somit übernehmen der Rückkopplungswiderstand $R_{V2}$ und die Schwingkreiskapazitäten C4, C5 die Aufgabe des Tiefpassfilters 26 und der Rückkopplungswiderstand $R_{V2}$ ebenfalls die Aufgabe des Aufrechterhaltens der Schwingung des Schwingkreises 32 durch den Rückkopplungswiderstand $R_V$ einer der zuvor beschriebenen Ausführungsformen.

Insbesondere sind in der Auswerteschaltung 30 der Ausführungsform der Figur 6 durch die Verschaltung der Schwingkreiskapazitäten C4 und C5 alle signalführenden Knoten kapazitiv mit dem niedrigen Versorgungspotenzial $V_{GND}$ verbunden. Dadurch ermöglicht der Aufbau des Schwingkreises 32 und dessen gegenphasige Anregung einen Aufbau der Auswerteschaltung 30 , mit dem Störeinflüsse auf die Auswerteschaltung 30 deutlich reduziert werden können.

Das Funktionsprinzip der Ausführungsform der Figur 6 entspricht dem der zuvor beschriebenen Ausführungsformen. Mithilfe der Offsetspannung $U_O$ wird ein Komparatorschwellenwert KS vorgegeben, durch den die Schaltung verstimmt werden kann. Auf diese Weise stellt sich ein von 50 % verschiedenes Tastverhältnis am Komparatorausgang ein, das sich aus der Offsetspannung $U_O$ und dem Spannungsniveau des Mittelwerts des Schwingungssignals S ergibt.

Zum Bereitstellen der Sensorgröße A ist ein dem Komparator 33 nachgeschalteter Tiefpassfilter 34 in Form eines RC-Gliedes vorgesehen, an dessen Zwischenknoten die Sensorgröße A als Gleichspannung abgenommen werden kann.

## Bezugszeichenliste

| | |
|---|---|
| 1 | Auswerteschaltung |
| 2 | Sensorelement |
| 20 | Auswerteschaltung |
| 21 | Sensorelement |
| 22 | Schwingkreis |
| 23 | erster Anschluss |
| 24 | zweiter Anschluss |
| 25 | Komparator |
| 26 | Tiefpassfilter |
| 27 | Offsetspannungsquelle |
| 3 | Schwingkreis |
| 30 | Auswerteschaltung |
| 31 | induktiver Sensor |
| 32 | Schwingkreis |
| 33 | Komparator |
| 34 | Tiefpassfilter |
| 35 | erster Anschluss der Induktivität L2 |
| 36 | zweiter Anschluss der Induktivität L2 |
| 37 | Phasenkorrektureinheit |
| 4 | Anregungseinrichtung |
| 5 | Komparator |
| 6 | Tiefpassfilter |
| 7 | Offset-Einheit |
| A | Sensorgröße (Sensorsignal) |
| C1 | Filterkapazität |
| C2, C3, C4, C5 | Schwingkreiskapazitäten |
| E1 | erster Eingang |
| E2 | zweiter Eingang |
| K | Komparatorsignal |
| K1 | erstes resultierendes Komparatorsignal |
| K2 | zweites resultierendes Komparatorsignal |
| KS | Komparatorschwellenwert |
| L1, L2 | Induktivitäten |
| O | Offsetwert |
| R1 | Filterwiderstand |
| $R_P$ | Widerstand |
| $R_{P2}$ | Widerstand |

| | |
|---|---|
| $R_V$ | Rückkopplungswiderstand |
| S | Schwingungssignal |
| S1 | erstes sinusförmiges Schwingungssignal |
| S2 | zweites sinusförmiges Schwingungssignal |
| ts1, ts2 | Zeitdauer |
| T | Periodendauer |
| $U_O$ | Offsetspannung |
| $U_a$ | Amplitude des Schwingungssignals |
| $U_R$ | Referenzspannung |
| $V_{GND}$ | niedriges Versorgungspotenzial |
| $V_V$ | hohes Versorgungspotenzial |

**Patentansprüche**

1. Verfahren zum Messen einer physikalischen Messgröße mit einem, insbesondere induktiven, Sensorelement (2, 21, 31) und zum Bereitstellen einer von der Messgröße abhängigen Sensorgröße (A),
   wobei das Sensorelement (2, 21, 31) Teil eines Schwingkreises (3, 22, 32) ist, der eine von der physikalischen Messgröße abhängige Dämpfung aufweist,
   wobei der Schwingkreis (3, 22, 32) angeregt wird, um ein periodisches Schwingungssignal (S, S1, S2) zu generieren, dessen Amplitude ($U_a$) von der Dämpfung abhängt;
   wobei das Schwingungssignal (S, S1, S2) mithilfe eines Komparators (5, 25, 33) mit einem Komparatorschwellenwert (KS) verglichen wird, um ein periodisches Komparatorsignal (K) mit einem von dem Komparatorschwellenwert (KS) abhängigen Tastverhältnis zu erhalten,
   **dadurch gekennzeichnet, dass** der Komparatorschwellenwert (KS) gegenüber einem Mittelwert des Schwingungssignals (S, S1, S2) so verstellt wird, dass sich ein von 50% verschiedenes Tastverhältnis einstellt,
   wobei die Sensorgröße (A) als eine von dem Tastverhältnis des Komparatorsignals (K) abhängige Größe bereitgestellt wird.

2. Verfahren nach Anspruch 1, wobei ein Mittelwert des Schwingungssignals (S, S1, S2) gegenüber dem Komparatorschwellenwert (KS) mithilfe eines vorgegebenen Offsetwerts (O), insbesondere einer vorgegebenen Offsetspan-nung ($U_O$), verstellt wird, wobei das Schwingungssignal (S, S1, S2) mit dem Offsetwert (O) beaufschlagt wird oder der Komparatorschwellenwert (KS) dem Offsetwert (O) entspricht oder abhängig von dem Offsetwert (O) eingestellt wird.

3. Verfahren nach Anspruch 1 oder 2, wobei der Komparatorschwellenwert (KS) abhängig von dem Tastverhältnis des periodischen Komparatorsignals (K) eingestellt wird.

4. Verfahren nach Anspruch 3, wobei der Komparatorschwellenwert (KS) als der, insbesondere durch Glätten erhaltene, Durchschnittswert des periodischen Komparatorsignals (K) eingestellt wird, wobei die Sensorgröße (A) dem Durchschnittswert entspricht.

5. Verfahren nach einem der Ansprüche 1 bis 4, wobei eine Oszillation des Schwingkreises (3, 22) durch gleichphasige Rückkopplung des periodischen Komparatorsignals (K) aufrechterhalten wird.

6. Verfahren nach einem der Ansprüche 1 bis 5, wobei das Komparatorsignal (K) tiefpassgefiltert wird, wobei ein Anschwingen des Schwingkreises (3, 22) durch Rückkopplung des tiefpassgefilterten Komparatorsignals (K) auf den Komparatorschwellenwert (KS) bewirkt wird.

7. Verfahren nach einem der Ansprüche 1 bis 6, wobei der Komparatorschwellenwert (KS) abhängig von dem Tastverhältnis des periodischen Komparatorsignals (K) und abhängig von einem vorgegebenen Offsetwert (O) gegenüber einem Mittelwert des Schwingungssignals (S, S1, S2) verstellt wird, so dass sich ein Gleichgewichtszustand zwischen einem sich aufgrund des vorgegebenen Offsetwerts (O) einstellenden Tastverhältnis und einem sich abhängig von dem Komparatorschwellenwert (KS) einstellenden Tastverhältnis ergibt.

8. Verfahren nach einem der Ansprüche 1 bis 7, wobei die Messgröße einer Spannung des Komparatorschwellenwerts (KS) oder einer effektiven, durch Glättung des periodischen Komparatorsignals (K) erhaltenen Spannung entspricht.

9. Verfahren nach einem der Ansprüche 1 bis 4, wobei der Schwingkreis (32) gegenphasig durch das periodische Komparatorsignal (K) angeregt wird.

10. Auswerteschaltung (1,20, 30) zum Messen einer physikalischen Messgröße mit einem, insbesondere induktiven, Sensorelement (2, 21, 31) und zum Bereitstellen einer von der Messgröße abhängigen Sensorgröße (A), wobei die Sensorgröße (A) als eine von dem Tastverhältnis des Komparatorsignals (K) abhängige Größe bereitgestellt wird; umfassend:

   - einen das Sensorelement (2, 21, 31) umfassenden Schwingkreis (3, 22, 32), der eine von der physikalischen Messgröße abhängige Dämpfung aufweist;
   - eine Einrichtung zum Bereitstellen eines Anregungssignals zum Anregen des Schwingkreises (3, 22, 32), um ein periodisches Schwingungssignal (S, S1, S2) zu generieren, dessen Amplitude ($U_a$) von der Dämpfung des Schwingkreises (3, 22, 32) abhängt;
   - einen Komparator (5, 25, 33), um das Schwingungssignal (S, S1, S2) mit einem Komparatorschwellenwert (KS) zu vergleichen, so dass ein resultierendes periodisches Komparatorsignal (K) mit einem von dem Komparatorschwellenwert (KS) abhängigen Tastverhältnis bereitgestellt wird;
   **gekennzeichnet durch**:
   - eine Einrichtung zum Verstellen des Komparatorschwellenwerts (KS) gegenüber einem Mittelwert des Schwingungssignals (S, S1, S2), so dass sich ein von 50% verschiedenes Tastverhältnis einstellt.

11. Auswerteschaltung (1, 20, 30) nach Anspruch 10, wobei eine Offsetspannungsquelle (27) vorgesehen ist, um den Mittelwert des Schwingungssignals (S, S1, S2) gegenüber dem Komparatorschwellenwert (KS) mithilfe eines vorgegebenen Offsetwerts (O), insbesondere einer vorgegebenen Offsetspannung ($U_o$), zu verstellen, wobei die Offsetspannungsquelle (27) so geschaltet ist, dass das Schwingungssignal (S, S1, S2) mit dem Offsetwert (O) beaufschlagt wird oder der Komparatorschwellenwert (KS) dem Offsetwert (O) entspricht oder abhängig von dem Offsetwert (O) eingestellt wird.

12. Auswerteschaltung (1, 20, 30) nach einem der Ansprüche 10 bis 11, wobei die Einrichtung zum Bereitstellen des Anregungssignals eine Rückkopplung des Komparatorsignals (K), insbesondere mithilfe eines Rückkopplungswiderstands ($R_v$), auf den Schwingkreis (3, 22, 32) vorsieht, um den Schwingkreis (3, 22, 32) durch das periodische Komparatorsignal (K) anzuregen, so dass dieser, insbesondere bei seiner Resonanzfrequenz, kontinuierlich schwingt.

13. Auswerteschaltung (1, 20, 30) nach Anspruch 12, wobei eine Anschwingeinrichtung vorgesehen ist, um das periodische Komparatorsignal (K) tiefpasszufiltern und um den Komparatorschwellenwert (KS) als das tiefpassgefilterte Komparatorsignal (K) oder als ein von dem tiefpassgefilterten Komparatorsignal (K) abhängiges Signal bereitzustellen, um ein Anschwingen des Schwingkreises (3, 22, 32) zu ermöglichen, wobei das tiefpassgefilterte Komparatorsignal (K) als die Sensorgröße (A) bereitgestellt wird.

14. Auswerteschaltung (30) nach Anspruch 12, wobei das Sensorelement (2, 21) eine Induktivität (L2) aufweist, wobei der Schwingkreis (32) die Induktivität (L2) aufweist, deren Anschlüsse jeweils über Schwingkreiskapazitäten (C4, C5) mit einem festgelegten Potenzial gekoppelt sind, wobei die Rückkopplung des Komparatorsignals (K) auf den Schwingkreis (32) gegenphasig erfolgt.

**Claims**

1. Method for measuring a measured physical quantity with a, in particular inductive, sensor element (2, 21, 31) and for providing a sensor quantity (A) depending on the measured quantity,
   wherein the sensor element (2, 21, 31) is part of a oscillating circuit (3, 22, 32) which has an attenuation depending on the measured physical quantity,
   the oscillating circuit (3, 22, 32) being excited to generate a periodic oscillating signal (S, S1, S2) whose amplitude (Ua) depends on the attenuation,
   wherein the oscillating signal (S, S1, S2) is compared with a comparator threshold value (KS) by means of a comparator (5, 25, 33) to obtain a periodic comparator signal (K) having a duty cycle depending on the comparator threshold value (KS);
   **characterized in that** the comparator threshold value (KS) is adjusted relative to an average value of the oscillation signal (S, S1, S2) such that a duty cycle different from 50% is set;

wherein the sensor quantity (A) is provided as a quantity depending on the duty cycle of the comparator signal (K).

2. Method according to claim 1, wherein an average value of the oscillation signal (S, S1, S2) is adjusted relative to the comparator threshold value (KS) by means of a predetermined offset value (O), in particular a predetermined offset voltage (Uo), wherein the offset value (O) is applied to the oscillation signal (S, S1, S2) or the comparator threshold value (KS) corresponds to the offset value (O) or is adjusted as a function of the offset value (O).

3. Method according to claim 1 or 2, wherein the comparator threshold value (KS) is set as a function of the duty cycle of the periodic comparator signal (K).

4. Method according to claim 3, wherein the comparator threshold value (KS) is set as the average value, obtained in particular by smoothing, of the periodic comparator signal (K), wherein the sensor quantity (A) corresponds to the average value.

5. Method according to one of claims 1 to 4, wherein an oscillation of the oscillating circuit (3, 22) is maintained by in-phase feedback of the periodic comparator signal (K).

6. Method according to one of claims 1 to 5, wherein the comparator signal (K) is low-pass filtered, wherein start oft he oscillation of the oscillating circuit (3, 22) is effected by feedback of the low-pass filtered comparator signal (K) to the comparator threshold value (KS).

7. Method according to one of claims 1 to 6, wherein the comparator threshold value (KS) is adjusted depending on the duty cycle of the periodic comparator signal (K) and depending on a predetermined offset value (O) relative to an average value of the oscillation signal (S, S1, S2), so that there is a state of equilibrium between a duty cycle resulting due to the predetermined offset value (O) and a duty cycle resulting due to the comparator threshold value (KS).

8. Method according to one of claims 1 to 7, wherein the measured quantity corresponds to a voltage of the comparator threshold value (KS) or an effective voltage obtained by smoothing the periodic comparator signal (K).

9. Method according to one of claims 1 to 4, wherein the oscillating circuit (32) is excited in antiphase by the periodic comparator signal (K).

10. Evaluation circuit (1, 20, 30) for measuring a physical quantity with an, in particular inductive, sensor element (2, 21, 31) and for providing a sensor quantity (A) depending on the measured quantity, wherein the sensor quantity (A) is provided as a quantity depending on the duty cycle of the comparator signal (K); comprising:

   - a oscillating circuit (3, 22, 32) comprising the sensor element (2, 21, 31) and having an attenuation depending on the measured physical quantity;
   - means for providing an excitation signal for exciting the oscillating circuit (3, 22, 32) in order to generate a periodic oscillation signal (S, S1, S2) whose amplitude (Ua) depends on the attenuation of the oscillating circuit (3, 22, 32);
   - a comparator (5, 25, 33) for comparing the oscillation signal (S, S1, S2) with a comparator threshold (KS) so as to provide a resulting periodic comparator signal (K) having a duty cycle depending on the comparator threshold (KS);
   **characterized by**:
   - means for adjusting the comparator threshold (KS) relative to an average value of the oscillation signal (S, S1, S2) so that a duty cycle different from 50% is established.

11. Evaluation circuit (1, 20, 30) according to claim 10, wherein an offset voltage source (27) is provided for adjusting the average value of the oscillation signal (S, S1, S2) relative to the comparator threshold value (KS) by means of a predetermined offset value (O), in particular by means of a predetermined offset voltage (UO), wherein the offset voltage source (27) is connected so that the offset value (O) is applied to the oscillation signal (S, S1, S2) or the comparator threshold value (KS) corresponds to the offset value (O) or is adjusted as a function of the offset value (O).

12. Evaluation circuit (1, 20, 30) according to one of claims 10 to 11, wherein the device for providing the excitation signal provides feedback of the comparator signal (K), in particular by means of a feedback resistor (RV), to the oscillating circuit (3, 22, 32) in order to excite the oscillating circuit (3, 22, 32) by the periodic comparator signal (K) so that the oscillating circuit (3, 22, 32) oscillates continuously, in particular at its resonance frequency.

**13.** Evaluation circuit (1, 20, 30) according to claim 12, wherein a startup unit is provided for low-pass filtering the periodic comparator signal (K) and for providing the comparator threshold value (KS) as the low-pass-filtered comparator signal (K) or as a signal depending on the low-pass-filtered comparator signal (K), to enable the oscillating circuit (3, 22, 32) to oscillate, wherein the low-pass filtered comparator signal (K) is provided as the sensor quantity (A).

**14.** Evaluation circuit (30) according to claim 12, wherein the sensor element (2, 21) has an inductance (L2), wherein the oscillating circuit (32) has the inductance (L2), the terminals of which are coupled to a fixed potential via oscillating circuit capacitances (C4, C5), respectively, wherein the feedback of the comparator signal (K) to the oscillating circuit (32) is in antiphase.

**Revendications**

**1.** Procédé pour mesurer une variable de mesure physique à l'aide d'un élément capteur, notamment inductif (2, 21, 31) et pour fournir une variable de capteur (A) en fonction de la variable de mesure,
dans lequel l'élément capteur (2, 21, 31) fait partie d'un circuit oscillant (3, 22, 32) qui présente une atténuation dépendante de la variable de mesure physique,
dans lequel le circuit oscillant (3, 22, 32) est excité pour générer un signal d'oscillation périodique (S, S1, S2), dont l'amplitude ($U_a$) dépend de l'atténuation ;
dans lequel le signal d'oscillation (S, S1, S2) est comparé à une valeur seuil (KS) de comparateur à l'aide d'un comparateur (5, 25, 33) afin d'obtenir un signal périodique (K) du comparateur avec un rapport cyclique dépendant de la valeur seuil (KS) de comparateur,
**caractérisé en ce que** la valeur seuil (KS) du comparateur est ajustée par rapport à une valeur moyenne du signal d'oscillation (S, S1, S2) de sorte qu'un rapport cyclique qui diffère de 50 % est réglé,
dans lequel la variable de capteur (A) est fournie comme une variable dépendante du rapport cyclique du signal (K) de comparateur.

**2.** Procédé selon la revendication 1, dans lequel une valeur moyenne du signal d'oscillation (S, S1, S2) est ajustée par rapport à la valeur seuil (KS) du comparateur à l'aide d'une valeur de décalage prédéterminée (O), en particulier d'une tension de décalage prédéterminée ($U_o$), le signal d'oscillation (S, S1, S2) étant soumis à la valeur de décalage (O) ou la valeur seuil (KS) du comparateur correspondant à la valeur de décalage (O) ou étant réglée en fonction de la valeur de décalage (O).

**3.** Procédé selon la revendication 1 ou 2, dans lequel la valeur seuil (KS) du comparateur est réglée en fonction du rapport cyclique du signal périodique (K) du comparateur.

**4.** Procédé selon la revendication 3, dans lequel la valeur seuil (KS) du comparateur est réglée comme la valeur moyenne, notamment obtenue par lissage, du signal périodique (K) du comparateur, la variable de capteur (A) correspondant à la valeur moyenne.

**5.** Procédé selon l'une des revendications 1 à 4, dans lequel une oscillation du circuit oscillant (3, 22) est maintenue par rétroaction en phase du signal périodique (K) du comparateur.

**6.** Procédé selon l'une des revendications 1 à 5, dans lequel le signal (K) du comparateur est filtré passe-bas, l'oscillation du circuit oscillant (3, 22) étant effectuée par rétroaction du signal (K) du comparateur filtré passe-bas sur la valeur seuil (KS) du comparateur.

**7.** Procédé selon l'une des revendications 1 à 6, dans lequel la valeur seuil (KS) du comparateur est ajustée en fonction du rapport cyclique du signal périodique (K) du comparateur et en fonction d'une valeur de décalage prédéterminée (O) par rapport à une valeur moyenne du signal d'oscillation (S, S1, S2), de sorte qu'il existe un état d'équilibre entre un rapport cyclique établi sur la base de la valeur de décalage prédéterminée (O) et un rapport cyclique établi en fonction de la valeur seuil (KS) du comparateur.

**8.** Procédé selon l'une des revendications 1 à 7, dans lequel la variable de mesure correspond à une tension de la valeur seuil (KS) du comparateur ou à une tension effective obtenue par le lissage du signal périodique (K) du comparateur.

**9.** Procédé selon l'une des revendications 1 à 4, dans lequel le circuit oscillant (32) est excité en opposition de phase par le signal périodique (K) du comparateur.

**10.** Circuit d'évaluation (1, 20, 30) servant à mesurer une variable de mesure physique à l'aide d'un élément capteur, notamment inductif (2, 21, 31), et à fournir une variable de capteur (A) en fonction de la variable de mesure, la variable de capteur (A) étant fournie comme une variable dépendante du rapport cyclique du signal (K) du comparateur ;

comprenant :

- un circuit oscillant (3, 22, 32) comprenant l'élément capteur (2, 21, 31) et ayant une atténuation dépendante de la variable de mesure physique ;
- un dispositif de fourniture d'un signal d'excitation pour exciter le circuit oscillant (3, 22, 32) afin de générer un signal d'oscillation périodique (S, S1, S2) dont l'amplitude ($U_a$) dépend de l'atténuation du circuit oscillant (3, 22, 32) ;
- un comparateur (5, 25, 33) pour comparer le signal d'oscillation (S, S1, S2) avec une valeur seuil (KS) de comparateur de sorte qu'un signal périodique (K) de comparateur résultant est fourni avec un rapport cyclique dépendant de la valeur seuil (KS) de comparateur ;

**caractérisé par** :

- un dispositif de réglage de la valeur seuil (KS) du comparateur par rapport à une valeur moyenne du signal d'oscillation (S, S1, S2) de manière à établir un rapport cyclique différent de 50 %.

**11.** Circuit d'évaluation (1, 20, 30) selon la revendication 10, dans lequel une source de tension de décalage (27) est prévue pour régler la valeur moyenne du signal d'oscillation (S, S1, S2) par rapport à la valeur seuil (KS) du comparateur à l'aide d'une valeur de décalage prédéterminée (O), en particulier d'une tension de décalage prédéterminée ($U_o$), la source de tension de décalage (27) étant connectée de sorte que le signal d'oscillation (S, S1, S2) est soumis à la valeur de décalage (O) ou que la valeur seuil (KS) du comparateur correspond à la valeur de décalage (O) ou est réglée en fonction de la valeur de décalage (O).

**12.** Circuit d'évaluation (1, 20, 30) selon l'une des revendications 10 et 11, dans lequel le dispositif de fourniture du signal d'excitation prévoit une rétroaction du signal (K) du comparateur, en particulier à l'aide d'une résistance de rétroaction ($R_v$), sur le circuit oscillant (3, 22, 32) pour exciter le circuit oscillant (3, 22, 32) par le signal périodique (K) du comparateur, de sorte que ledit circuit oscille en continu, notamment à sa fréquence de résonance.

**13.** Circuit d'évaluation (1, 20, 30) selon la revendication 12, dans lequel un dispositif de démarrage est prévu pour filtrer passe-bas le signal périodique (K) du comparateur et pour fournir la valeur seuil (KS) du comparateur comme signal (K) du comparateur filtré passe-bas ou comme un signal dépendant du signal (K) du comparateur filtré passe-bas, pour permettre au circuit oscillant (3, 22, 32) de démarrer, le signal (K) du comparateur filtré passe-bas étant fourni comme la variable de capteur (A).

**14.** Circuit d'évaluation (30) selon la revendication 12, dans lequel l'élément capteur (2, 21) présente une inductance (L2), le circuit oscillant (32) présentant l'inductance (L2), dont les connexions sont couplées chacune par le biais de capacités de circuit oscillant (C4, C5) avec un potentiel fixe, la rétroaction du signal (K) du comparateur sur le circuit oscillant (32) ayant lieu en opposition de phase.

Fig. 1

Fig. 2

Fig. 3

Fig. 4

Fig. 5

**Fig. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004034190 A1
- EP 1183779 B1
- EP 0537747 A2
- EP 2146431 A2